# EUROPEAN PATENT APPLICATION

(11) **EP 3 101 522 A1**
(43) Date of publication of application: **07.12.2016**
(21) Application number: 14881134.2
(22) Date of filing: 01.12.2014
(51) Int. Cl.: G06F 3/0488, G06F 3/01, G06F 3/041

(54) **INFORMATION PROCESSING DEVICE, INFORMATION PROCESSING METHOD, AND PROGRAM**

(30) Priority: 28.01.2014 JP 2014013626
(71) Applicant: Sony Corporation, Tokyo 108-0075 (JP)
(72) Inventor: YAMANO, Ikuo, Tokyo 108-0075 (JP)
(74) Representative: MFG Patentanwälte Meyer-Wildhagen Meggle-Freund Gerhard PartG mbB
(86) International application number: PCT/JP2014/081780
(87) International publication number: WO 2015/114938

(57) **Abstract**

[Object] To propose a method for increase the number of variations of operations even in the case of a small operation face.

[Solution] Provided is an information processing apparatus including a processing unit configured to execute a process corresponding to an operation performed on a terminal having an operation face. The processing unit acquires sensing results from a first sensing unit and a second sensing unit, the first sensing unit sensing contact or adjacency of an operation body to the operation face, the second sensing unit sensing a movement of the terminal, and executes a process corresponding to the acquired sensing result of contact or adjacency of the operation body, and the acquired sensing result of the movement of the terminal.

## Description

### Technical Field

The present disclosure relates to an information processing apparatus, an information processing method, and a program.

### Background Art

In recent years, electronic devices equipped with a touch panel or a touch pad (hereinafter, referred to as touch panel) as an input unit, such as a portable phone, is becoming widespread. This kind of electronic devices detect a position at which an operation body performs a touch operation to an operation face of the touch panel, as a pointing position.

Patent Literature 1 discloses a technology for preventing an input operation mistake due to improper pressing on the touch panel or the like.

### Citation List

### Patent Literature

Patent Literature 1: JP 2012-27875A

### Summary of Invention

### Technical Problem

In the electronic devices, sizes of touch panels are limited so as to ensure portability and the like. In the case of a small touch panel, operations to be performed are limited, and unfortunately, it may be difficult to fulfill functions of the electronic device effectively.

Therefore, the present disclosure proposes a method for increase the number of variations of operations even in the case of a small operation face.

### Solution to Problem

According to the present disclosure, there is provided an information processing apparatus including a processing unit configured to execute a process corresponding to an operation performed on a terminal having an operation face. The processing unit acquires sensing results from a first sensing unit and a second sensing unit, the first sensing unit sensing contact or adjacency of an operation body to the operation face, the second sensing unit sensing a movement of the terminal, and executes a process corresponding to the acquired sensing result of contact or adjacency of the operation body, and the acquired sensing result of the movement of the terminal.

According to the present disclosure, there is provided an information processing method including: acquiring sensing results from a first sensing unit and a second sensing unit, the first sensing unit sensing contact or adjacency of an operation body to an operation face of a terminal, the second sensing unit sensing a movement of the terminal; and executing, by a processor, a process corresponding to the acquired sensing result of contact or adjacency of the operation body, and the acquired sensing result of the movement of the terminal.

According to the present disclosure, there is provided a program causing a computer to execute: acquiring sensing results from a first sensing unit and a second sensing unit, the first sensing unit sensing contact or adjacency of an operation body to an operation face of a terminal, the second sensing unit sensing a movement of the terminal; and executing a process corresponding to the acquired sensing result of contact or adjacency of the operation body, and the acquired sensing result of the movement of the terminal.

### Advantageous Effects of Invention

As described above, according to the present disclosure, it is possible to increase the number of variations of operations even in the case of a small operation face.

Note that the above effects are not necessarily restrictive, but any effect described in the present specification or another effect that can be grasped from the present specification may be achieved in addition to the above effects or instead of the above effects.

### Brief Description of Drawings

[FIG. 1] FIG. 1 is a schematic diagram illustrating an example of an exterior structure of a wristband terminal 10 according to a first embodiment of the present disclosure.
[FIG. 2] FIG. 2 is a diagram illustrating touch operation to an operation face 14 of a wristband terminal 10 according to a first embodiment.
[FIG. 3] FIG. 3 is a diagram illustrating how a wristband terminal 10 is turned toward a first direction while a finger touches an operation face 14.
[FIG. 4] FIG. 4 is a diagram illustrating how a wristband terminal 10 is turned toward a second direction while a finger touches an operation face 14.
[FIG. 5] FIG. 5 is a diagram illustrating touch operation of two fingers to an operation face 14.
[FIG. 6] FIG. 6 is a block diagram illustrating an example of a function and configuration of an information processing apparatus 100 according to a first embodiment.
[FIG. 7] FIG. 7 is a schematic diagram illustrating an example of zooming in of a display in a display screen image of a display unit 13.
[FIG. 8] FIG. 8 is a schematic diagram illustrating an example of zooming out of a display in a display screen image of a display unit 13.
[FIG. 9] FIG. 9 is a flowchart illustrating an exemplary operation of an information processing apparatus 100 according to a first embodiment.
[FIG. 10] FIG. 10 is a schematic diagram illustrating a variant example of an operation face 14.
[FIG. 11] FIG. 11 is a diagram illustrating an example of performing touch operation to a smartphone 30.
[FIG. 12] FIG. 12 is a schematic diagram for describing an example of a contact state of a finger when a finger moves relative to an operation face 14.
[FIG. 13] FIG. 13 is a schematic diagram for describing contact and non-contact determination methods in a capacitive touch panel.
[FIG. 14] FIG. 14 is a schematic diagram illustrating a relationship between a moving amount of a finger and a moving amount of a contact position of a finger when the finger moves relative to an operation face 14.
[FIG. 15] FIG. 15 is a schematic diagram illustrating a relationship between a moving amount of a finger and a moving amount of a contact position of a finger when the finger moves relative to an operation face 14.
[FIG. 16] FIG. 16 is a block diagram illustrating an example of a function and configuration of an information processing apparatus 150 according to a second embodiment.
[FIG. 17] FIG. 17 is a graph illustrating a relationship between a contact position in a longitudinal direction of an operation face 14 and a threshold value.
[FIG. 18] FIG. 18 is a graph illustrating a relationship between a contact position in a longitudinal direction of an operation face 14 and a scroll amount.
[FIG. 19] FIG. 19 is a graph illustrating a relationship between an amount of change in a contact area and a scroll amount.
[FIG. 20] FIG. 20 is a flowchart illustrating an exemplary operation of an information processing apparatus 150 when executing a control of a contact determination threshold value.
[FIG. 21] FIG. 21 is a flowchart illustrating an exemplary operation of an information processing apparatus 150 when executing a gain control of a scroll amount.
[FIG. 22] FIG. 22 is an explanatory diagram illustrating an exemplary hardware configuration of an information processing apparatus 100 according to an embodiment.

### Description of Embodiment(s)

Hereinafter, preferred embodiments of the present disclosure will be described in detail with reference to the appended drawings. Note that, in this specification and the appended drawings, structural elements that have substantially the same function and structure are denoted with the same reference numerals, and repeated explanation of these structural elements is omitted.

Note that description will be made in the following order.
1. First Embodiment
   1-1. Configuration of Wristband terminal
   1-2. Exemplary Operation of Wristband terminal
   1-3. Function and Configuration of Information Processing Apparatus
   1-4. Operation of Information Processing Apparatus
   1-5. Conclusion
2. Second Embodiment
   2-1. Problem occurring in Operation Face of Curved Surface
   2-2. Function and Configuration of Information Processing Apparatus
   2-3. Operation of Information Processing Apparatus
   2-4. Conclusion
3. Hardware Configuration

### <1. First Embodiment>

### (1-1. Configuration of Wristband terminal)

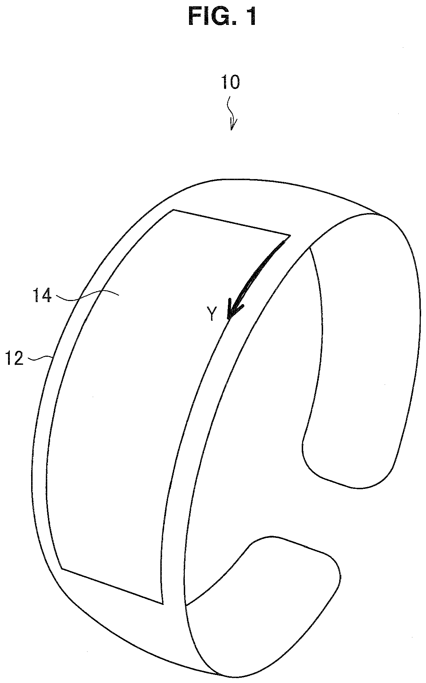

With reference to FIG. 1, description will be made of an example of the configuration of a wristband terminal equipped with an information processing apparatus according to the first embodiment of the present disclosure.

FIG. 1 is a schematic diagram illustrating an example of the exterior structure of the wristband terminal 10 according to the first embodiment. The wristband terminal 10 is a wearable terminal worn on a part of the arm or the wrist of a user, for example. This wristband terminal 10 allows the user to quickly operate and confirm the information displayed on the display screen, without taking the wristband terminal 10 from a bag or a pocket.

As illustrated in FIG. 1, the wristband terminal 10 has a touch panel display (simply, referred to as the touch panel) 12 having the function of a display unit and an operation unit. The touch panel 12 is provided at a part of the region of the whole circumference of the wristband terminal 10, to allow the user to perform touch operation easily, for example. Note that the touch panel 12 is not limited thereto, but may be provided on the whole circumference of the wristband terminal 10.

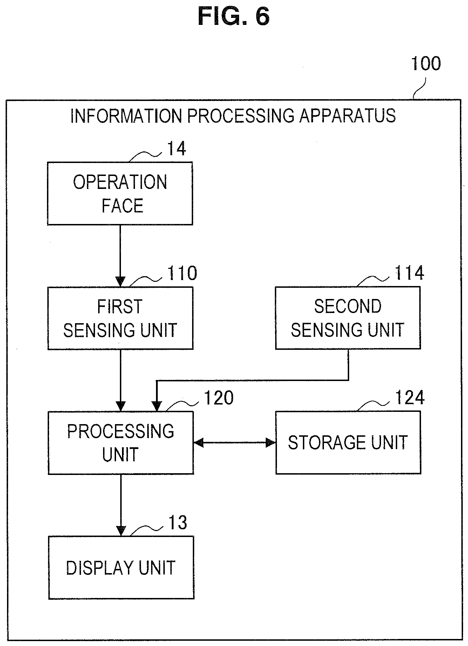

The display unit 13 (FIG. 6) displays a text, an image, and other information on the display screen. The display of the text, the image, and other information by the display unit 13 is controlled by a processing unit 120 (FIG. 6) described later. The display unit 13 is, for example, a liquid crystal display, an organic EL display, or the like.

The operation face 14 is an operation unit and is superposed on the display unit 13. The operation face 14 has a curved surface along the outer circumferential direction of the arm of the user. The operation face 14 may include a plurality of parts having different curvatures. The user performs touch operation on the operation face 14, while looking at the display screen of the display unit 13. The touch operation means an operation that decides the input when a finger contacts the operation face 14, or an operation that decides the input when a finger contacts the operation face 14 and disengages from the operation face 14 (what is called a tap).

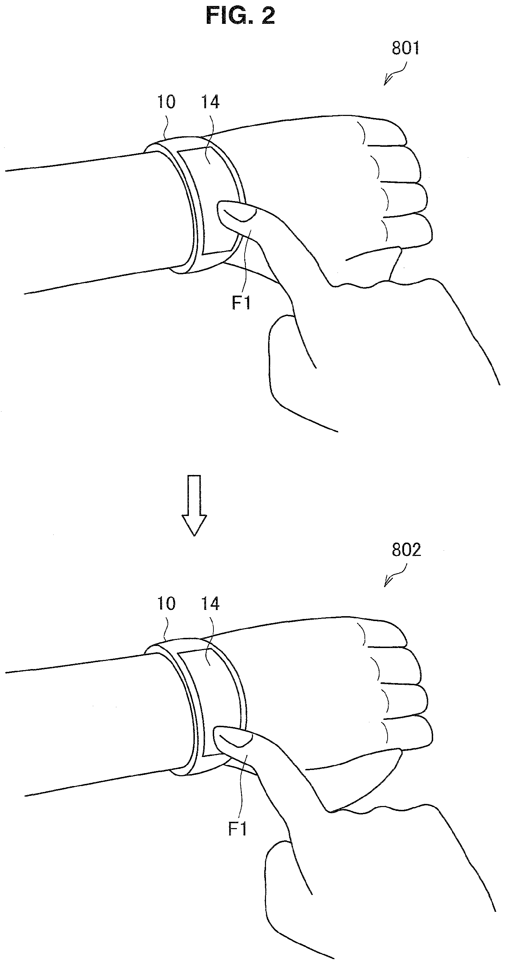

Usually, in order to realize various functions in the wristband terminal, it is desirable that the area of the touch panel 12 is large. However, if a large touch panel that protrudes from the arm width of the user is arranged, the wearability and the operability of the wristband terminal deteriorate. Also, if the touch panel is arranged along the longitudinal direction of the arm of the user, the touch panel might be hidden under clothes. Hence, the touch panel 12 according to the first embodiment has a shape extending around the wrist with a curved surface and a short width (refer to FIG. 2).

### (1-2. Exemplary Operation of Wristband terminal 10)

In the meantime, the wristband terminal makes it difficult to perform common touch operation with what is called a smartphone or the like, due to the limitation of the shape and the size of the touch panel. Also, if one tries to operate the touch panel with two fingers, a large part of the display screen is hidden by two fingers, which makes it difficult to operate while looking at the content of the display screen image.

In contrast, the wristband terminal 10 according to the first embodiment realizes various variations of operations, by turning the wristband terminal 10 while performing touch operation to the operation face 14 of the touch panel 12,. In the following, description will be made of an exemplary operation in the wristband terminal 10 with reference to FIGS. 2 to 4.

FIG. 2 is a diagram illustrating the touch operation to the operation face 14 of the wristband terminal 10 according to the first embodiment. In FIG. 2, as illustrated in the state 801, the index finger F1 of the right arm touches the operation face 14 of the wristband terminal 10 worn on the left arm. Thereafter, as illustrated in the state 802, the index finger F1 moves in the longitudinal direction (Y direction of FIG. 1) while touching the operation face 14. This operation scrolls the display screen image, for example.

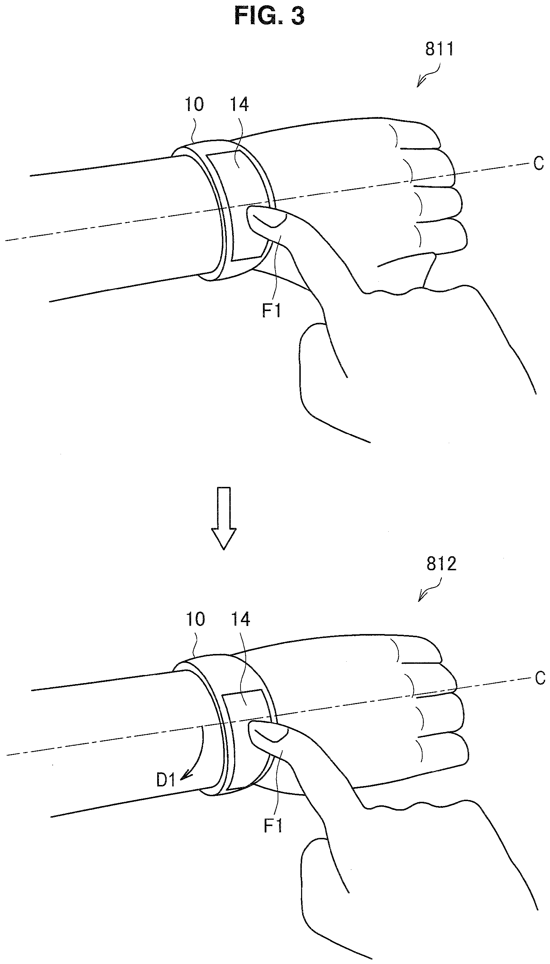

FIG. 3 is a diagram illustrating how the wristband terminal 10 is turned toward the first direction while the finger touches the operation face 14. In FIG. 3, as illustrated in the state 811, the index finger F1 of the right arm touches the operation face 14 of the wristband terminal 10 worn on the left arm. Thereafter, as illustrated in the state 812, the left arm wearing the wristband terminal 10 is rotated in the direction D1 (the first direction) with respect to the center at the axis C, while the index finger F1 touches the operation face 14 in an almost fixed state. This operation zooms in the display screen image, for example.

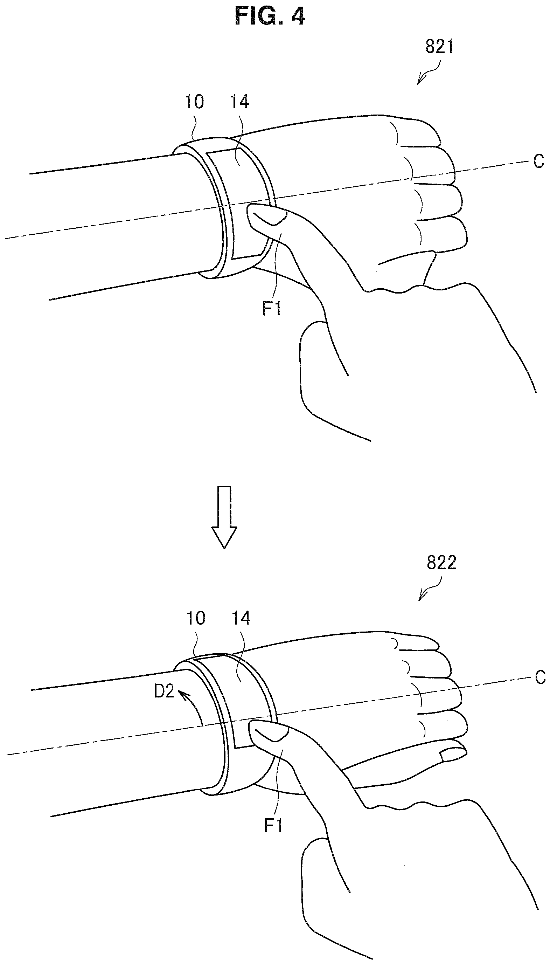

FIG. 4 is a diagram illustrating how the wristband terminal 10 is turned toward the second direction while the finger touches the operation face 14. In FIG. 4 as well, as illustrated in the state 821, the index finger F1 of the right arm touches the operation face 14 of the wristband terminal 10 worn on the left arm. Thereafter, as illustrated in the state 822, the left arm wearing the wristband terminal 10 is rotated in the direction D2 (the second direction) with respect to the center at the axis C, while the index finger F1 touches the operation face 14 in an almost fixed state. That is, the left arm is rotated in the opposite direction in relation to FIG. 3. This operation zooms out the display screen image, for example.

In the exemplary operation described in FIGS. 3 and 4, the wristband terminal 10 is rotated without moving the index finger F1, to realize a specific operation. Hence, the various operations are realized, even when the area of the operation face 14 on which the index finger F1 performs touch operation is small.

In the above, the display screen image is zoomed in when the left arm is rotated in the direction D1 as illustrated in FIG. 3, and the display screen image is zoomed out when the left arm is rotated in the direction D2 as illustrated in FIG. 4, but the operation is not limited thereto. For example, the web browser may return to a previous page when the left arm is rotated in the direction D1 as illustrated in FIG. 3, and the web browser may proceed to the next page when the left arm is rotated in the direction D2. Also, the web browser may register the page as a bookmark when the left arm is rotated in the direction D1 as illustrated in FIG. 3, and the web browser may return to the top of the page when the left arm is rotated in the direction D2.

Although in the above the left arm is rotated in the direction D1 or the direction D2 while the index finger F1 touches the operation face 14 in an almost fixed state, the operation is not limited thereto. For example, the left arm may be rotated in the direction D1 or the direction D2, while the index finger F1 is touches the operation face 14 and moves. In this case, the scroll amount may be, for example, two times the scroll amount of the screen image by the operation using only the index finger F1 as described in FIG. 2.

Also, if the wristband terminal 10 is rotated when the index finger F1 moves in the downward direction (Y direction of FIG. 1) (the scrolling of the screen image), the following display may be performed. For example, when the above operation is performed, the wristband terminal 10 may decide that the user is trying to return to the top of the page at once, and scroll the web page to the top at once. Also, when the above operation is performed, the wristband terminal 10 may return to the last web page, or may end the application.

Like this, various variations of operations are realized by combining the touch operation to the operation face 14 by the index finger F1 and the rotation of the wristband terminal 10.

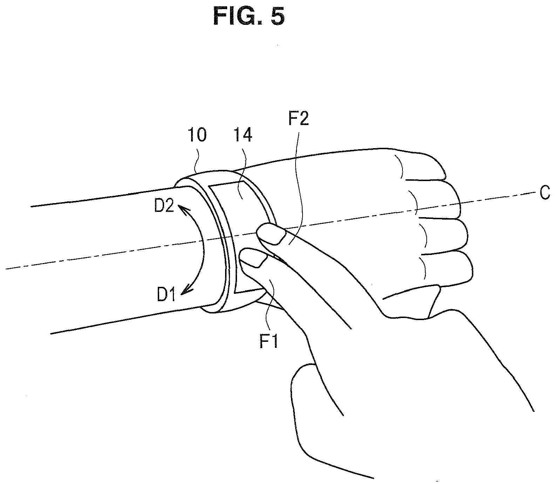

Although the above example has illustrated the touch operation to the operation face 14 by one finger, the operation is not limited thereto. For example, as illustrated in FIG. 5, the multi-touch operation may be performed to the operation face 14 by two fingers.

FIG. 5 is a diagram illustrating touch operation of two fingers to an operation face 14. In FIG. 5, the index finger F1 and the middle finger F2 touch the operation face 14. Then, when the wristband terminal 10 is rotated in the direction D1 with the index finger F1 and the middle finger F2 in an almost fixed state, the display screen image is zoomed in. On the other hand, when the wristband terminal 10 is rotated in the direction D2 with the index finger F1 and the middle finger F2 in an almost fixed state, the display screen image is zoomed out. That is, the display screen image is zoomed in or zoomed out, without pinching in or pinching out with the index finger F1 and the middle finger F2.

Since the operation face 14 of the wristband terminal 10 is small as described above, it is difficult to pinch in or pinch out on the operation face 14 with two fingers. In contrast, according to the present embodiment, even if the operation face 14 is small, the display screen image is zoomed in or zoomed out with two fingers touching the operation face 14. Also, according to the present embodiment, unintentional zooming in or zooming out of the screen image is prevented from occurring even when two fingers unintentionally move despite the user's intention to scroll the screen image.

Although the above description has been made taking the finger as an example of the operation body, the operation body is not limited thereto. For example, the operation body may be a pen. Also, although in the above the scrolling and other operations of the display screen image are performed by bringing the finger in touch (contact) with the operation face 14, the operation is not limited thereto. For example, the scrolling and other operations of the display screen image may be performed by bringing a finger adjacent to the operation face 14.

Further, although the above description has been made taking the touch panel 12 having the operation face 14 superposed on the display screen as an example, the present disclosure is not limited thereto. For example, the touch operation may be performed to a touch pad with the finger. That is, the present disclosure is applicable to both of the configuration having the operation face 14 and the display unit 13 superposed one on the other, and the configuration having the operation face 14 and the display unit 13 not superposed but separated from each other.

### (1-3. Function and Configuration of Information Processing Apparatus)

With reference to FIG. 6, description will be made of an example of the function and configuration of the information processing apparatus 100 according to the first embodiment, for realizing various variations of operations described above. In the following, description will be made of the above wristband terminal 10 having the function of the information processing apparatus 100.

FIG. 6 is a block diagram illustrating an example of the function and configuration of the information processing apparatus 100 according to the first embodiment. As illustrated in FIG. 6, the information processing apparatus 100 includes a first sensing unit 110, a second sensing unit 114, a processing unit 120, and a storage unit 124, in addition to the display unit 13 and the operation face 14 described above.

### (First Sensing Unit 110)

The first sensing unit 110 senses contact or adjacency of the operation body to the operation face 14. For example, the first sensing unit 110 senses the touch of the finger to the operation face 14 of the wristband terminal 10. The first sensing unit 110 is capable of sensing the number of the fingers touching the operation face 14.

The first sensing unit 110 is configured by a touch sensor, for example. The touch sensor is, for example, of the electrostatic capacitance type, the infrared light type, or the like. For example, the first sensing unit 110 determines that the finger touches the operation face 14, when the contact area of the touching finger on the operation face 14 is larger than a predetermined region.

Also, the finger in contact with the operation face 14 is also determined from the shape of the contact area of the finger to the operation face 14. For example, if the contact shape is horizontally long, the first sensing unit 110 determines the finger is the thumb, and if the shape is circular or vertically long, the first sensing unit 110 determines that the finger is the index finger or the middle finger. Also, since the contact area is different depending on the contacting finger, the finger may be determined from the size of the contact area sensed by the first sensing unit 110.

### (Second Sensing Unit 114)

The second sensing unit 114 senses the movement of the wristband terminal 10. For example, the second sensing unit 114 is capable of sensing the rotational movement of the wristband terminal 10. The second sensing unit 114 is also capable of sensing the rotation direction of the wristband terminal 10 (for example, the direction D1 illustrated in FIG. 3 and the direction D2 illustrated in FIG. 4).

The second sensing unit 114 is configured by an acceleration sensor and a gyro sensor, for example. Thereby, the second sensing unit 114 is also capable of sensing various movement form (gesture, etc) other than the rotational movement of the wristband terminal 10.

### (Processing Unit 120)

The processing unit 120 executes the process corresponding to the operation performed on the wristband terminal 10 having the operation face 14. For example, the processing unit 120 acquires the sensing results from the first sensing unit 110 and the second sensing unit 114, and executes the process corresponding to the acquired sensing result of contact or adjacency of the operation body (finger, etc), and the sensing result of the movement of the wristband terminal 10. Thereby, the processes are executable in response to the various operations using contact or adjacency of the finger and the movement of the wristband terminal 10.

The processing unit 120 may execute the display of the display unit 13, in response to the sensing result of contact or adjacency of the operation body and the sensing result of the movement of the wristband terminal 10, as one example of the process. Thereby, the various operations are performable to the display on the display unit 13.

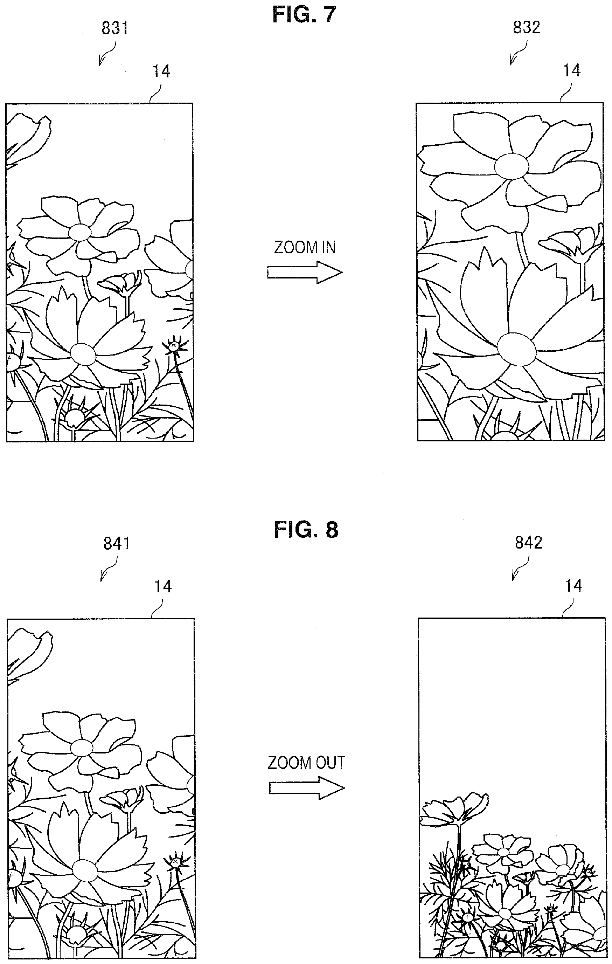

The processing unit 120 executes different processes, depending on the direction toward which the wristband terminal 10 rotationally moves with the operation body in a contact or adjacent state. Thereby, various processes are executed by rotationally moving the wristband terminal 10, without moving the operation body on the operation face 14. Here, description will be made of the relationship between the rotation direction of the wristband terminal 10 and the display of the display screen image, with an example, with reference to FIGS. 7 and 8.

FIG. 7 is a schematic diagram illustrating an example of zooming in of the display in the display screen image of the display unit 13. Before zooming in, the screen image illustrated in the state 831 is displayed. Thereafter, as described in FIG. 3 for example, when the wristband terminal 10 is rotated toward the direction D1 with the index finger F1 touching the operation face 14 in an almost fixed state, the screen image is zoomed in as illustrated in the state 832.

FIG. 8 is a schematic diagram illustrating an example of zooming out of the display in the display screen image of the display unit 13. Before zooming out, the screen image illustrated in the state 841 is displayed. Thereafter, as described in FIG. 4 for example, when the wristband terminal 10 is rotated toward the direction D2 with the index finger F1 touching the operation face 14 in an almost fixed state, the screen image is zoomed out as illustrated in the state 832.

The processing unit 120 differentiates the process executed when the movement of the wristband terminal 10 and contact or adjacency of the operation body are sensed, from the process executed when contact or adjacency of the operation body is sensed while the movement of the wristband terminal 10 is not sensed. Thereby, different processes are executed, depending on the presence or absence of the movement of the wristband terminal 10.

The processing unit 120 differentiates the process executed when contact or adjacency of the operation body is sensed first and the movement of the wristband terminal 10 is sensed later, from the process executed when the movement of the wristband terminal 10 is sensed first and contact or adjacency of the operation body is sensed later. Thereby, different processes are executed, depending on the order of contact or adjacency of the operation body and the movement of the wristband terminal 10.

Note that, when the movement of the wristband terminal 10 is sensed while the operation body is in contact with or adjacent to the operation face 14, the processing unit 120 may regard a series of the operations as the operation of the operation body. Thereby, even when the wristband terminal 10 erroneously moves during the operation of the operation body, the different operation is prevented from being executed.

As described above, a plurality of fingers can be in contact with or adjacent to the operation face 14. Therefore, the processing unit 120 may execute the process corresponding to the sensing result of contact or adjacency of a plurality of fingers and the sensing result of the movement of the wristband terminal 10. Thereby, even when multi-touch is performed to the operation face 14 having a small area by a plurality of fingers, the types of the operations are increased by using the movement of the wristband terminal 10.

The processing unit 120 may execute different processes, depending on the finger that is in contact or adjacent. For example, in the case where the finger touching the operation face 14 moves while the wristband terminal 10 is moved in the operation of the web browser, if the finger touching the operation face 14 is the index finger, the processing unit 120 causes the web browser to move to the top of the page, and if the finger touching the operation face 14 is the thumb, the processing unit 120 causes the web browser to return to the previous page. Note that the finger touching the operation face 14 is determinable from the shape and the size of the contact area when contacting the operation face 14 as described above.

### (Storage Unit 124)

The storage unit 124 stores the programs executed by the processing unit 120, and the information used in the processes by the processing unit 120. For example, the storage unit 124 stores the information of the threshold value for determining the contact state of the finger.

Although in the above the wristband terminal 10 includes the processing unit 120, the wristband terminal 10 is not limited thereto. For example, the processing unit 120 may be provided in a server capable of communicating with the wristband terminal 10 via a network. In this case, the processing unit 120 of the server controls the display of the display unit 13 on the basis of the sensing results of the first sensing unit 110 and the second sensing unit 114 of the wristband terminal 10. Hence, the server functions as the information processing apparatus.

Also, although in the above the processing unit 120 automatically executes the process corresponding to the sensing result of contact or adjacency of the operation body (finger, etc) and the sensing result of the movement of the wristband terminal 10, the operation is not limited thereto. For example, the setting of whether or not the above process is executable (ON/OFF) is switchable by the user. When the setting is ON, the above process may be executed. On the other hand, when the setting is OFF, the process corresponding to the sensing result of contact or adjacency of the operation body may be executed, regardless of the movement of the wristband terminal 10.

### (1-4. Operation of Information Processing Apparatus)

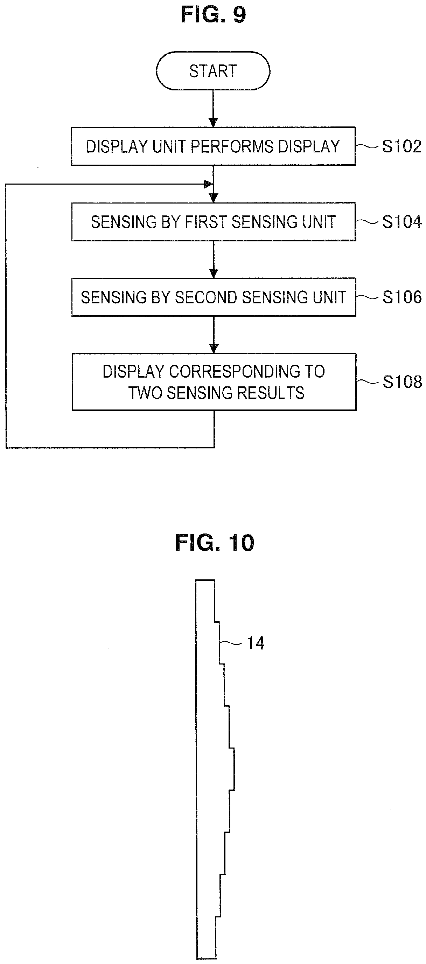

With reference to FIG. 9, description will be made of an example of the operation of the information processing apparatus 100 according to the first embodiment.

FIG. 9 is a flowchart illustrating the exemplary operation of the information processing apparatus 100 according to the first embodiment. The process illustrated in FIG. 9 is realized by the CPU of the information processing apparatus 100 executing a program stored in the ROM. Note that the executed program may be stored in a recording medium such as a CD (Compact Disk), a DVD (Digital Versatile Disk), and a memory card, or may be downloaded from a server or other devices via the Internet.

The flowchart of FIG. 9 starts from performing display on the display unit 13 of the wristband terminal 10 (step S102). Thereafter, the user performs the touch operation to the operation face 14, and rotates the wristband terminal 10.

Thereafter, the first sensing unit 110 (FIG. 6) senses contact or adjacency of the operation body to the operation face 14 (step S104). For example, the first sensing unit 110 senses the touch of the finger to the operation face 14 of the wristband terminal 10. Thereafter, the second sensing unit 114 (FIG. 6) senses the movement of the wristband terminal 10 (step S106). For example, the second sensing unit 114 senses the rotational movement of the wristband terminal 10.

Although in the above the sensing by the second sensing unit 114 is executed after the sensing by the first sensing unit 110, the operation is not limited thereto. For example, the sensing may be executed in reverse order, or the sensing of the first sensing unit 110 and the sensing of the second sensing unit 114 may be executed simultaneously.

Thereafter, the processing unit 120 acquires the sensing results from the first sensing unit 110 and the second sensing unit 114, and controls the process corresponding to the acquired sensing result of contact or adjacency of the operation body and the sensing result of the movement of the wristband terminal 10, for example the display of the display unit 13 (step S108). This allows the display unit 13 to present the various display, as compared with the operation on the operation face 14 only.

Although in the above the operation face 14 of the wristband terminal 10 is a curved surface, the operation face 14 is not limited thereto. For example, the operation face 14 may be a flat surface. Also, although in the above the operation face 14 is a curved surface spreading smoothly as illustrated in FIG. 1, the operation face 14 is not limited thereto, but may be shaped as illustrated in FIG. 10, for example.

FIG. 10 is a schematic diagram illustrating a variant example of the operation face 14. As illustrated in FIG. 10, the operation face 14 may be a stepped surface (in FIG. 10, the steps are illustrated in a more exaggerated manner than it really is), which does not spread smoothly, for example. In this case as well, the surface of the operation face 14 is a shape like a curved surface.

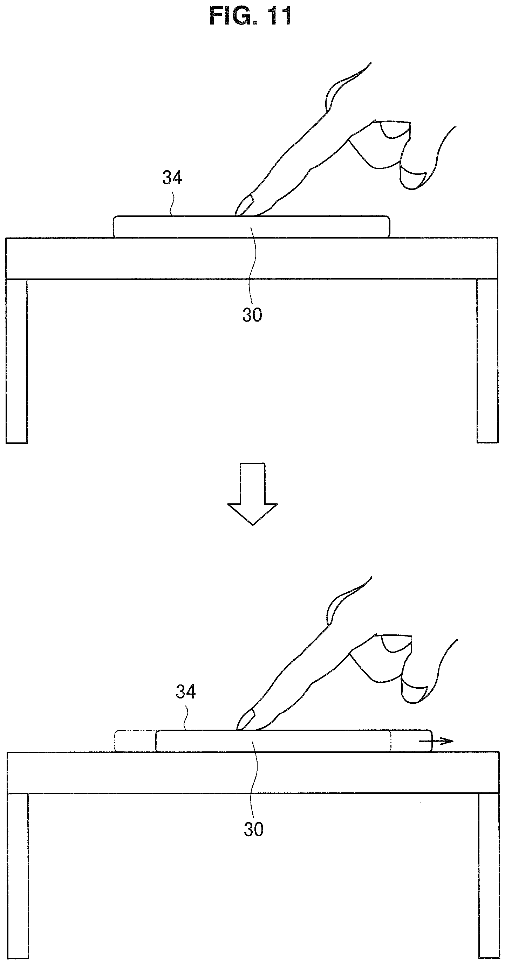

Although in the above the terminal equipped with the information processing apparatus 100 is the wristband terminal 10, the configuration is not limited thereto. For example, the information processing apparatus 100 may be equipped in a smartphone 30 as illustrated in FIG. 11.

FIG. 11 is a diagram illustrating an example of performing the touch operation to the smartphone 30. For example, the user puts the smartphone on the desk, and performs touch operation to the operation face 34 with a finger. In doing this, the user performs the touch operation with the finger, as well as moves the smartphone 30 in a translatory manner. Hence, the second sensing unit 114 senses the translatory movement of the smartphone 30. As a result, in the smartphone 30 as well, the variations of the operations are increased by combining the touch operation of the finger and the movement of the smartphone 30. In particular, this is effective in a small smartphone 30.

### (1-5. Conclusion)

According to the first embodiment, the processing unit 120 of the information processing apparatus 100 acquires the sensing results from the first sensing unit 110 and the second sensing unit 114, and executes the process corresponding to the acquired sensing result of contact or adjacency of the operation body (finger, etc) and the sensing result of the movement of the wristband terminal 10.

In this case, the variations of the operations are increased, and the types of the executable processes are also increased, by using contact or adjacency of the finger to the operation face 14 and the movement of the wristband terminal 10. In particular, even when the area of the operation face 14 is small as in the wristband terminal 10, various operations including the multi-touch operation are realized.

### <2. Second Embodiment>

### (2-1. Problem occurring in Operation Face of Curved Surface)

The operation face 14 of the wristband terminal 10 described above is the curved surface as illustrated in FIG. 1. The shape of the operation face 14 can cause a following problem. Here, although description will be made of an example in which the touch operation is performed with the finger (operation body) to the operation face 14, the operation is not limited to bringing the finger into contact with the operation face 14. The same problem can occur when bringing the finger adjacent to the operation face 14.

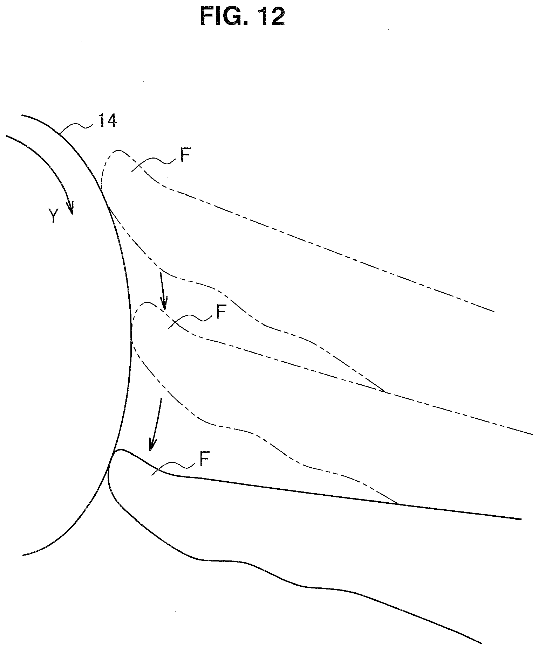

FIG. 12 is a schematic diagram for describing an example of the contact state of the finger when the finger moves relative to the operation face 14. As illustrated in FIG. 12, when the finger F is positioned at the upper end side in the longitudinal direction (Y direction) of the operation face 14, a part of the finger pad contacts the operation face 14. However, when the finger moves to the lower end side in the longitudinal direction, a part of the fingertip contacts the operation face 14. The contact area of the part of the finger pad contacting the operation face 14 is large, whereas the contact area of the part of the fingertip contacting the operation face 14 is small. Like this, the contact position and the contact area of the finger are different, depending on the position of the finger relative to the operation face 14. In particular, when the curvature of the operation face 14 is small, the above becomes prominent.

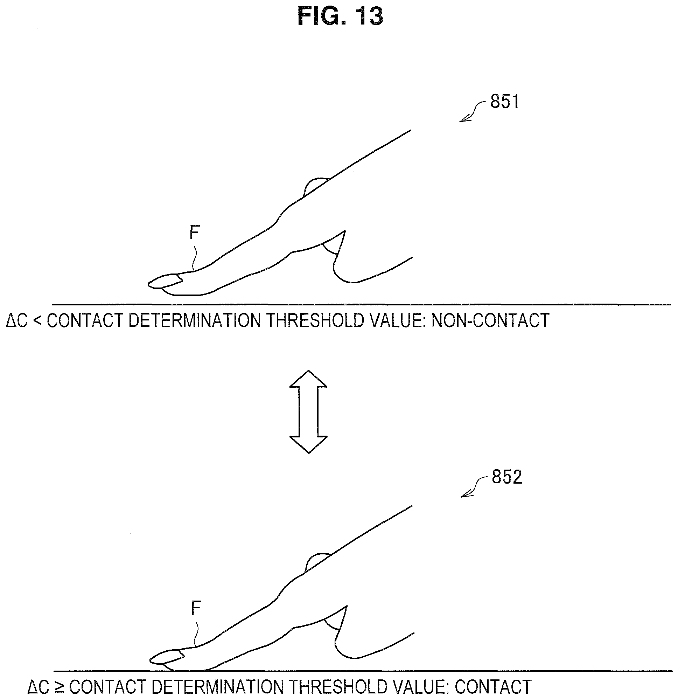

FIG. 13 is a schematic diagram for describing the contact and non-contact determination method in the capacitive touch panel. In the determination of the past illustrated in FIG. 13, the contact and non-contact is determined based on whether or not the change value ΔC of the electrostatic capacitance when the finger F contacts the touch panel exceeds a predetermined threshold value (constant value). The change value ΔC depends on the contact area of the finger, and the threshold value is set constant over the entire touch panel. In the state 851 of FIG. 13, the non-contact is determined because the change value ΔC is smaller than the threshold value. In the state 852, the contact is determined because the change value ΔC is equal to or larger than the threshold value.

However, when the operation face 14 is the curved surface, the contact area of the finger in the lower end side in the longitudinal direction of the operation face 14 is small as described in FIG. 12, and the change value ΔC is smaller than the threshold value, and therefore the non-contact might be determined even when the finger contacts the operation face 14. Conversely, if the threshold value for the entire touch panel is made smaller, the false detection may happen due to noise and other reasons.

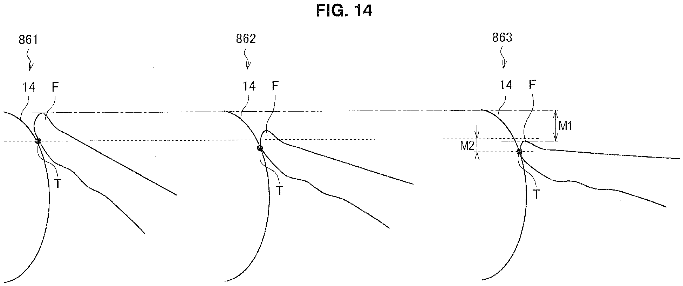

FIG. 14 is a schematic diagram illustrating the relationship between the moving amount of the finger and the moving amount of the contact position of the finger when the finger moves relative to the operation face 14. Here, in order to scroll the screen image for example, the finger F moves from the upper end side to the lower end side in the longitudinal direction as illustrated in FIG. 14. In this case, the contact position T of the finger shifts as described in FIG. 12. This is because, as illustrated in FIG. 14, the finger is oblique to the operation face 14 in the state 861, and the finger becomes more perpendicular to the operation face 14 as the finger changes to the state 862 and the state 863.

Hence, when the finger moves from the state 861 via the state 862 to the state 863, the moving amount of the contact position of the finger M2 relative to the operation face 14 is smaller than the moving amount of the finger M1. As a result, the screen image might be scrolled in a different manner from the user's intention.

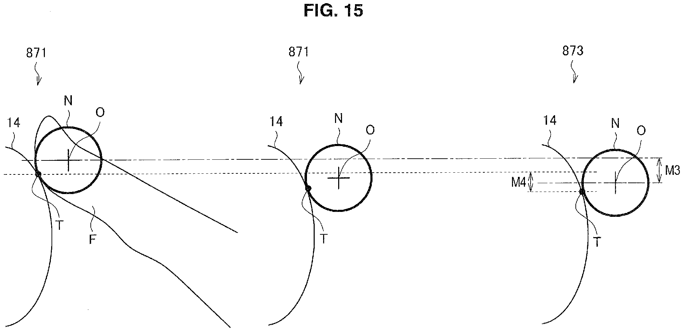

Although in FIG. 14 the contact position is changed by making the state of the finger more perpendicular to the operation face 14, the operation is not limited thereto. For example, even when the finger is not perpendicular, the contact position of the finger changes as illustrated in FIG. 15.

FIG. 15 is a schematic diagram illustrating the relationship between the moving amount of the finger and the moving amount of the contact position of the finger when the finger moves relative to the operation face 14. In FIG. 15, the state of the finger F that is oblique to the operation face 14 as illustrated in the state 871 continues in the state 872 and the state 873 as well. Also, in FIG. 15, the shape of the finger is depicted with a circle N. In this case, the contact position T of the finger is positioned on the line linking the curvature center of the operation face 14 and the center O of the circle N. Thus, if the circle is moved downward, the moving amount M4 of the contact position T of the finger is smaller than the actual moving amount M3 of the finger in the same way as FIG. 14. As a result, the screen image is scrolled in a different manner from the user's intention.

### (2-2. Function and Configuration of Information Processing Apparatus)

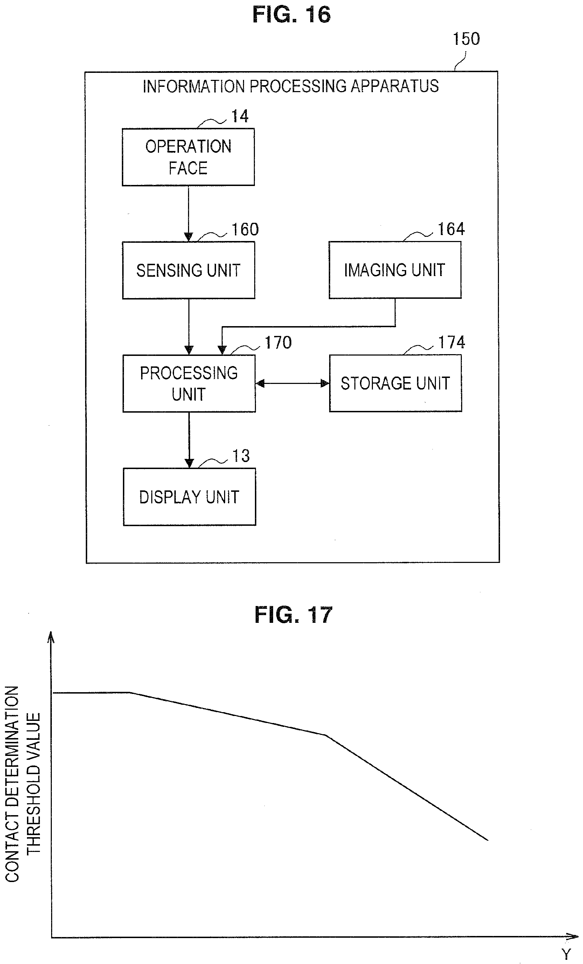

In order to solve the above problem, the information processing apparatus according to the second embodiment has the function and configuration illustrated in FIG. 16, and executes the control describe below. In the second embodiment as well, description will be made of the wristband terminal 10 having the function of the information processing apparatus 150.

FIG. 16 is a block diagram illustrating an example of the function and configuration of the information processing apparatus 150 according to the second embodiment. As illustrated in FIG. 16, the information processing apparatus 150 includes a sensing unit 160, an imaging unit 164, a processing unit 170, and a storage unit 174, in addition to the display unit 13 and the operation face 14 described above.

### (Sensing Unit 160)

The sensing unit 160 senses contact or adjacency of the operation body to the operation face 14. For example, the sensing unit 160 senses the touch of the finger to the operation face 14 of the wristband terminal 10. The sensing unit 160 transmits the sensing result to the processing unit 170.

The sensing unit 160 is configured by the touch sensor, for example. The electrostatic capacitance method is used here for the touch sensor, but the method is not limited thereto. For example, the infrared light method or other methods may be used. When the contact area of the touching finger to the operation face 14 is larger than a predetermined region, the sensing unit 160 determines that the finger is in touch with the operation face 14.

### (Imaging Unit 164)

The imaging unit 164 captures an image of the user touching the operation face 14 with the finger. For example, the imaging unit 164 captures an image of the face of the user. The imaging unit 164 is a camera provided around the operation face 14, for example. The imaging unit 164 transmits the image capturing result to the processing unit 170.

### (Processing Unit 170)

The processing unit 170 has a function of acquiring the signal from the sensing unit and executing a predetermined process in response to the position and the movement of the operation body detected on the basis of the signal. The processing unit 170 changes at least one of the sensing degree by the sensing unit 160 and the control parameter for executing a predetermined process, in response to the position of the operation body relative to the operation face 14.

The processing unit 170 is capable of determining the curvature for each position of the operation face 14 at which the operation body is positioned. Therefore, the processing unit 170 may change at least one of the sensing degree by the sensing unit 160 and the control parameter corresponding to the movement of the operation body, in response to the curvature of the operation face 14 at which the operation body is positioned. Thereby, the control is executed to solve the above problem arising from the contact position relative to the operation face 14 and the curvature of the operation face 14.

When the contact state of the operation body to the operation face 14 is larger than a predetermined contact degree, the processing unit 170 determines that the operation body contacts the operation face 14. Then, as illustrated in FIG. 17, the processing unit 170 changes the threshold value indicating a predetermined contact degree, in response to the position of the operation body.

FIG. 17 is a graph illustrating the relationship between the contact position in the longitudinal direction of the operation face 14 and the threshold value. The horizontal axis of the graph represents the contact position of the finger in the longitudinal direction. As read from the graph, the processing unit 170 makes the threshold value large at the upper end side (the side at which the value of Y is 0) in the longitudinal direction, and makes the threshold value smaller toward the lower end side in the longitudinal direction. Thereby, the threshold value corresponding to the actual contact state of the finger is appropriately set.

Also, the processing unit 170 may change the threshold value indicating a predetermined contact degree, in response to the curvature of the operation face 14 at which the operation body is positioned. For example, the processing unit 170 may make the threshold value smaller when the curvature of the operation face 14 is small, and make the threshold value larger when the curvature of the operation face 14 is large. Thereby, even when the finger contacts a small area of the operation face 14 having a small curvature, the contact and non-contact is appropriately detected. Even when the contact position of the horizontal axis is replaced by the curvature of the operation face 14 in the graph illustrated in FIG. 17, like tendency exists.

Although in the above the horizontal axis of the graph illustrated in FIG. 17 is the contact position or the curvature, the horizontal axis is not limited thereto. For example, the horizontal axis of the graph may be the movement distance of the finger touching the operation face 14. In this case, the threshold value may be made larger when the movement distance is small, and the threshold value may be made smaller when the movement distance is large. This is because the larger movement distance makes the contact area more likely to be small. Also, the horizontal axis of the graph may be a value combining the contact position in the longitudinal direction, the movement distance, and the curvature.

In the meantime, the processing unit 170 may change the threshold value in response to the relationship between the position of the finger contacting the operation face 14 and the sight line of the user. For example, the processing unit 170 determines the position relationship between the face of the operator and the operation body, on the basis of the image of the operator looking at the operation face 14 captured by the imaging unit 164. Then, the processing unit 170 changes the threshold value indicating a predetermined contact degree, in response to the determined position relationship.

Specifically, when determining that the face is positioned at the upper side of the operation body, the processing unit 170 makes the threshold value larger. When determining that the face is positioned at the lower side of the operation body, the processing unit 170 makes the threshold value smaller. Thereby, the optimal threshold value is set in consideration of the touch situation to the operation face 14. Although in the above the image of the face is acquired to change the threshold value, the operation is not limited thereto. For example, the sight line may be detected to change the threshold value.

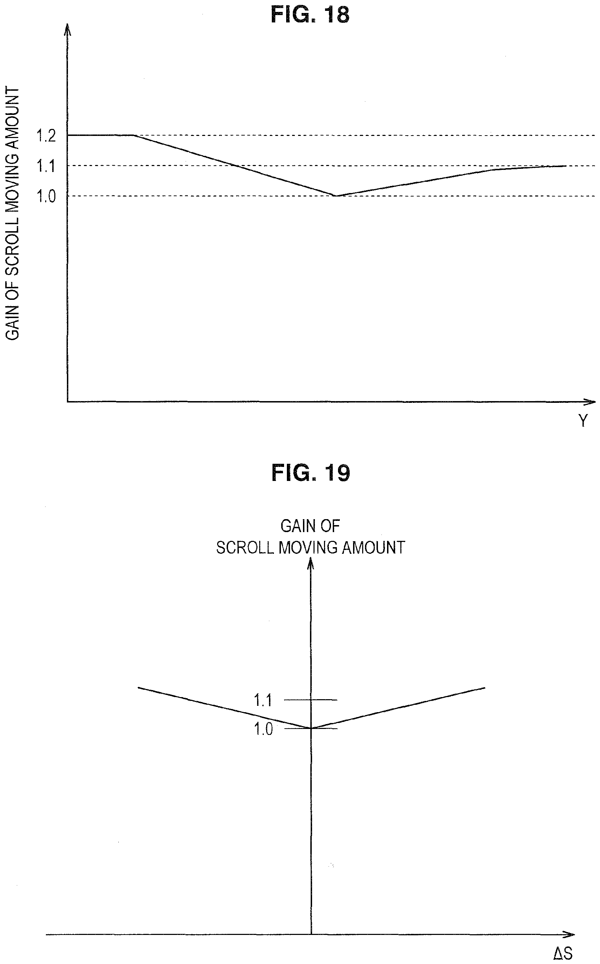

The processing unit 170 changes the parameter of the control of the screen display in the display unit 13 according to the movement of the operation body, in response to the position and the curvature of the operation face 14 at which the operation body is positioned, as the control parameter. Specifically, as illustrated in FIG. 18, the processing unit 170 changes the scroll amount of the screen image relative to the moving amount of the operation body, in response to the position of the operation body.

FIG. 18 is a graph illustrating the relationship between the contact position in the longitudinal direction of the operation face 14 and the scroll amount. As read from the graph, the processing unit 170 makes the scroll amount large (gained) at the end portion in the longitudinal direction, and does not make the scroll amount large at the center portion in the longitudinal direction. Also, since the contact states of the finger are slightly different at the upper end side and the lower end side in the longitudinal direction, the magnitudes of the gain are differentiated so as to reflect the states. Thereby, the scrolling of the screen image reflecting the user's intention is executed in such a manner to correspond to the actual motion of the finger. Note that the horizontal axis of the graph of FIG. 18 may be a value combining the contact position, the movement distance of the finger in the longitudinal direction, and the curvature.

The processing unit 170 may change the scroll amount of the screen image relative to the moving amount of the operation body, in response to the curvature of the operation face 14 at which the operation body is positioned. For example, the processing unit 170 may make the scroll amount larger as the curvature of the operation face 14 is smaller. Thereby, when the curvature of the operation face 14 is small so that the moving amount of the contact position is small relative to the actual movement of the finger, the scroll amount is made larger to scroll the screen image in accordance with the user's intention. As a result, regardless of the contact position of the operation face 14 and the curvature of the operation face 14, the screen image is scrolled with steady feeling.

Although in the above the scroll amount is controlled in response to the contact position of the finger on the operation face 14, the operation is not limited thereto. For example, as illustrated in FIG. 19, the processing unit 170 may control the scroll amount in response to the change of the contact area of the finger to the operation face 14.

FIG. 19 is a graph illustrating the relationship between the amount of change in the contact area and the scroll amount. In the graph of FIG. 19, the horizontal axis represents the amount of change ΔS in the contact area. The processing unit 170 does not gain the scroll amount when the contact area does not change and remains at a predetermined value, whereas the processing unit 170 gains the scroll amount when the contact area changes. Specifically, the processing unit 170 gains the scroll amount largely, as the amount of change ΔS becomes larger. Note that the horizontal axis of the graph of FIG. 19 may be a value combining the amount of change in the contact area and the movement distance of the finger in the longitudinal direction.

The above relationship between the amount of change in the contact area and the scroll amount is applicable not only to the terminal equipped with the information processing apparatus 150, in the form of the wristband terminal 10, but also to a terminal having a flat surface touch panel like the smartphone illustrated in FIG. 11, as well as to the terminal having a flat surface touch pad, such as a remote control and a notebook PC. Note that when the above relationship is applied to the touch pad, the control parameter may be the moving amount of the cursor displayed on the screen image, which is different from the scroll amount of the screen image.

### (Storage Unit 174)

The storage unit 174 stores the programs executed by the processing unit 170, and the information used in the processes by the processing unit 170. For example, the storage unit 174 stores the information of the threshold value for determining the contact state of the finger.

Although in the above the wristband terminal 10 includes the processing unit 170, the wristband terminal 10 is not limited thereto. For example, the processing unit 170 may be provided in a server capable of communicating with the wristband terminal 10 via a network. In this case, the processing unit 170 of the server controls the display of the display unit 13 on the basis of the sensing result of the sensing unit 160 of the wristband terminal 10. Hence, the server functions as the information processing apparatus.

Also, although in the above the processing unit 170 automatically changes at least one of the sensing degree by the sensing unit 160 (the contact determination threshold value) and the control parameter for executing a predetermined process (the scroll amount) in response to the position of the operation body relative to the operation face 14, the operation is not limited thereto. For example, the setting of whether or not the above process is executable (ON/OFF) is switchable by the user. When the setting is ON, the above process may be executed. On the other hand, when the setting is OFF, the contact determination threshold value and the scroll amount may be kept constant, regardless of the position of the operation body.

### (2-3. Operation of Information Processing Apparatus)

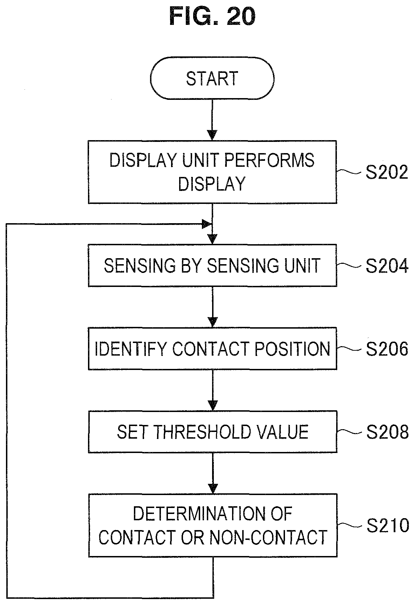

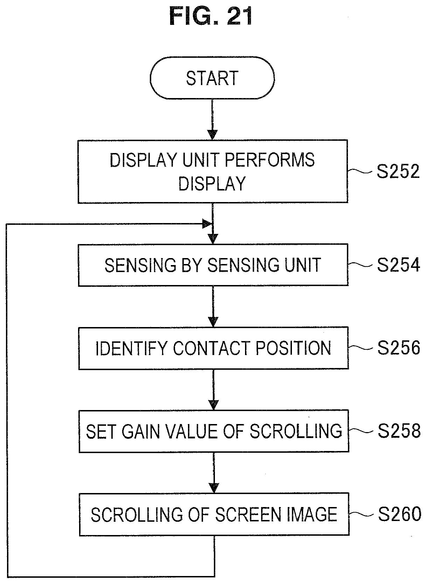

Description will be made of an exemplary operation of the information processing apparatus according to the second embodiment 150 described above. In the following, the control of the contact determination threshold value will be described with reference to FIG. 20, and then the gain control of the scroll amount will be described with reference to FIG. 21.

Note that the controls illustrated in FIGS. 20 and 21 are realized by the CPU of the information processing apparatus 150 executing a program stored in the ROM. Note that the executed program may be stored in a recording medium such as a CD (Compact Disk), a DVD (Digital Versatile Disk), and a memory card, or may be downloaded from a server or other devices via the Internet.

### (Control of Contact Determination Threshold Value)

FIG. 20 is a flowchart illustrating an exemplary operation of the information processing apparatus 150 when executing the control of the contact determination threshold value.

The flowchart of FIG. 20 starts from displaying of the display unit 13 of the wristband terminal 10 (step S202). Thereafter, the user performs the touch operation to the operation face 14, and rotates the wristband terminal 10.

Thereafter, the sensing unit 160 senses contact or adjacency of the operation body to the operation face 14 (step S204). Here, the sensing unit 160 senses the touch of the finger to the operation face 14 of the wristband terminal 10.

Thereafter, the processing unit 170 identifies the contact position of the operation body to the operation face 14 (step S206). Thereby, the processing unit 170 identifies the curvature of the operation face 14 at the contact position contacted by the operation body.

Thereafter, the processing unit 170 sets a threshold value used in the contact and non-contact determination, in response to the contact position of the operation body and the curvature of the operation face 14 at the contact position (step S208). For example, the processing unit 170 makes the threshold value smaller when the curvature of the operation face 14 is small, and makes the threshold value larger when the curvature of the operation face 14 is large.

Thereafter, the processing unit 170 determines the subsequent contact or non-contact of the finger to the operation face 14, on the basis of the set threshold value, (step S210). Thereby, even when the contact area of the finger to the operation face 14 is small, the contact and non-contact of the finger is appropriately determined. Thereafter, the above process (step S204 to S210) is repeated.

### (Gain Control of Scroll Amount)

FIG. 21 is a flowchart illustrating an exemplary operation of the information processing apparatus 150 when executing the gain control of the scroll amount.

The flowchart of FIG. 21 is also started from displaying of the display unit 13 of the wristband terminal 10 (step S252). Thereafter, the sensing unit 160 senses contact or adjacency of the operation body to the operation face 14 (step S254), so that the processing unit 170 identifies the contact position of the operation body to the operation face 14 (step S256). Thereby, the processing unit 170 identifies the curvature of the operation face 14 at the contact position contacted by the operation body.

Thereafter, the processing unit 170 sets a gain value of the scrolling of the screen image relative to the moving amount of the operation body, in response to the contact position of the operation body and the curvature of the operation face 14 at the contact position, (step S258). For example, the processing unit 170 makes the scroll amount larger, as the curvature of the operation face 14 becomes smaller.

Thereafter, the processing unit 170 scrolls the screen image in response to the set gain value (step S260). Thereby, the scrolling of the screen image reflecting the user's intention is executed in such a manner to correspond to the actual motion of the finger. Thereafter, the above process (step S254 to S260) is repeated.

### (2-4. Conclusion)

According to the second embodiment, the processing unit 170 of the information processing apparatus 150 changes the threshold value for determining the contact and non-contact of the operation body to the operation face 14, in response to the position of the operation body relative to the operation face 14. Thereby, the threshold value corresponding to the actual contact state of the finger is appropriately set to appropriately determine the contact and non-contact of the operation body.

Also, the processing unit 170 changes the scroll amount of the screen image relative to the moving amount of the operation body, in response to the position of the operation body relative to the operation face 14. Thereby, the screen image is scrolled with steady feeling, regardless of the contact position of the operation face 14 and the curvature of the operation face 14.

Although, in the first embodiment and the second embodiment described above, the wristband terminal 10 is taken as an example for description, the configuration is not limited thereto. The following configuration may be also employed.

For example, the above sensing method of contact or adjacency of the operation body to the operation face 14 may be applied to an apparatus that detects the position of the operation body (finger, hand, or stylus) by the image recognition using the image capturing device such as a camera. Also, the gain control of the scroll amount described above may be applied to, for example, an apparatus that executes the pointing operation by the finger pointing of the user from the position away from the operation face (the display screen) (specifically, an apparatus that recognizes the position on the operation face (the display screen) pointed by the finger in the image recognition). Further, the display to the non-planar display unit described above may be applied to the display such as a non-planar LCD and an OLED, as well as an apparatus that performs projection to a non-planar surface using a projector.

### <3. Hardware Configuration>

The operation by the information processing apparatus 100 (as well as the information processing apparatus 150) described above is realized by the cooperation of the hardware configuration and the software of the information processing apparatus 100. Therefore, in the following, the hardware configuration of the information processing apparatus 100 will be described.

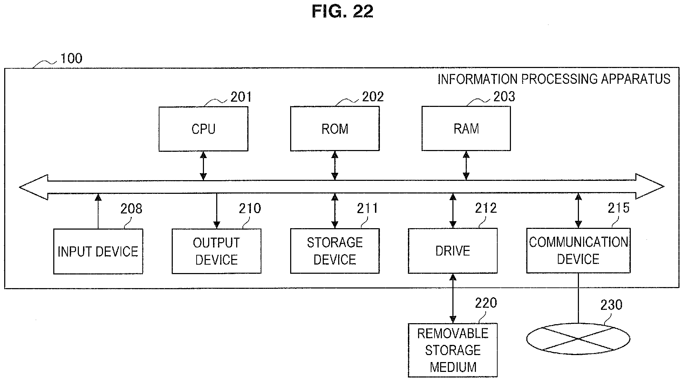

FIG. 22 is an explanatory diagram illustrating the exemplary hardware configuration of the information processing apparatus 100 according to an embodiment. As illustrated in FIG. 22, the information processing apparatus 100 includes a CPU (Central Processing Unit) 201, a ROM (Read Only Memory) 202, a RAM (Random Access Memory) 203, an input device 208, an output device 210, a storage device 211, a drive 212, and a communication device 215.

The CPU 201 functions as an operation processor and a control device, and controls the overall operation of the information processing apparatus 100 in accordance with various types of programs. Also, the CPU 201 may be a microprocessor. The ROM 202 stores programs, operation parameters, and other data used by the CPU 201. The RAM 203 temporarily stores the programs used in the execution of the CPU 201, the parameters that change as appropriate in the execution of the programs, and other data. They are connected to each other by a host bus configured from a CPU bus and others.

The input device 208 is composed of a mouse, a keyboard, a touch panel, a touch pad, a button, a microphone, an input mechanism for the user to input information such as a switch and a lever, an input control circuit that generates an input signal on the basis of input by the user and outputs the input signal to the CPU 201, and others. The user of the information processing apparatus 100 operates the input device 208, in order to input the various types of data to the information processing apparatus 100 and instruct the processing operation.

The output device 210 includes a display device, such as for example a liquid crystal display (LCD) device, an organic light emitting diode (OLED) device, and a lamp. Further, the output device 210 includes an audio output device such as a speaker and a headphone. For example, the display device displays a captured image, a generated image, and the like. On the other hand, the audio output device converts sound data to sound and outputs the sound.

The storage device 211 is a device for data storage which is configured as one example of the storage unit of the information processing apparatus 100 according to the present embodiment. The storage device 211 may include a storage medium, a recording device that records data on a storage medium, a reading device that reads out data from a storage medium, a deleting device that deletes data recorded on a storage medium, and a like. The storage device 211 stores programs and various types of data executed by the CPU 201.

The drive 212 is a storage medium reader/writer, which is provided either inside or outside the information processing apparatus 100. The drive 212 reads out the information recorded on a removable storage medium 220 such as a magnetic disk, an optical disc, a magneto-optical disk, or a semiconductor memory mounted thereon, and output to the RAM 203. Also, the drive 212 is capable of writing information on the removable storage medium 220.

The communication device 215 is, for example, a communication interface configured by a communication device for connecting to the network 230 and other devices. Also, the communication device 215 may be a wireless LAN (Local Area Network) compatible communication device, a LTE (Long Term Evolution) compatible communication device, or a wire communication device that communicates via wire.

Note that, the network 230 is a wired or wireless transmission channel of the information transmitted from a device connected to the network 230. For example, the network 230 may include public line networks such as the Internet, a telephone line network, a satellite communication network, various types of local area networks (LAN) including the Ethernet (registered trademark), wide area networks (WAN), and others. Also, the network 230 may include dedicated line networks such as IP-VPN (Internet Protocol-Virtual Private Network).

It should be understood by those skilled in the art that various modifications, combinations, subcombinations and alterations may occur depending on design requirements and other factors insofar as they are within the scope of the appended claims or the equivalents thereof.

Also, the effects described in the present specification are only explanatory and exemplary, and are not restrictive. That is, the technology according to the present disclosure can achieve other effects which are obvious for a person skilled in the art from the description of the present specification, in addition to the above effects or instead of the above effects.

Additionally, the present technology may also be configured as below.
(1) An information processing apparatus including
   a processing unit configured to execute a process corresponding to an operation performed on a terminal having an operation face,
   wherein the processing unit
   acquires sensing results from a first sensing unit and a second sensing unit, the first sensing unit sensing contact or adjacency of an operation body to the operation face, the second sensing unit sensing a movement of the terminal, and
   executes a process corresponding to the acquired sensing result of contact or adjacency of the operation body, and the acquired sensing result of the movement of the terminal.
(2) The information processing apparatus according to (1),
   wherein the operation face has a curved surface.
(3) The information processing apparatus according to (1) or (2),
   wherein the terminal is a wristband terminal that is worn on an arm of an operator.
(4) The information processing apparatus according to (3),
   wherein the movement of the terminal is a rotational movement.
(5) The information processing apparatus according to (4),
   wherein the processing unit executes a different process, depending on a direction toward which the terminal rotationally moves with the operation body in a contact or adjacent state.
(6) The information processing apparatus according to any one of (1) to (5)
   wherein the processing unit differentiates a process executed when the movement of the terminal and contact or adjacency of the operation body are sensed, from a process executed when contact or adjacency of the operation body is sensed while the movement of the terminal is not sensed.,
(7) The information processing apparatus according to any one of (1) to (6)
   Wherein the processing unit causes a display unit to present a display corresponding to the sensing result of contact or adjacency of the operation body and the sensing result of the movement of the terminal.
(8) The information processing apparatus according to (7),
   wherein the operation face is superposed on the display unit.
(9) The information processing apparatus according to any one of (1) to (8),
   wherein the processing unit differentiates a process executed when contact or adjacency of the operation body is sensed first and the movement of the terminal is sensed later, from a process executed when the movement of the terminal is sensed first and contact or adjacency of the operation body is sensed later.
(10) The information processing apparatus according to any one of (1) to (9),
   wherein the operation body is a plurality of fingers of an operator, and
   wherein the processing unit executes a process corresponding to a sensing result of contact or adjacency of the plurality of fingers and the sensing result of the movement of the terminal.
(11) The information processing apparatus according to (10),
   wherein the processing unit executes a different process, depending on the finger that is in contact or adjacent.
(12) The information processing apparatus according to (1),
   wherein the operation face is a flat surface.
(13) The information processing apparatus according to (12),
   wherein the movement of the terminal is a translatory movement.
(14) An information processing method including:
   acquiring sensing results from a first sensing unit and a second sensing unit, the first sensing unit sensing contact or adjacency of an operation body to an operation face of a terminal, the second sensing unit sensing a movement of the terminal; and
   executing, by a processor, a process corresponding to the acquired sensing result of contact or adjacency of the operation body, and the acquired sensing result of the movement of the terminal.
(15) A program causing a computer to execute:
   acquiring sensing results from a first sensing unit and a second sensing unit, the first sensing unit sensing contact or adjacency of an operation body to an operation face of a terminal, the second sensing unit sensing a movement of the terminal; and
   executing a process corresponding to the acquired sensing result of contact or adjacency of the operation body, and the acquired sensing result of the movement of the terminal.

### Reference Signs List

- 10: wristband terminal
- 12: touch panel
- 13: display unit
- 14: operation face
- 100: information processing apparatus
- 110: first sensing unit
- 114: second sensing unit
- 120: processing unit
- 150: information processing apparatus
- 160: sensing unit
- 170: processing unit
- F: finger
- T: contact position

## Claims

1. An information processing apparatus comprising
a processing unit configured to execute a process corresponding to an operation performed on a terminal having an operation face,
wherein the processing unit
acquires sensing results from a first sensing unit and a second sensing unit, the first sensing unit sensing contact or adjacency of an operation body to the operation face, the second sensing unit sensing a movement of the terminal, and
executes a process corresponding to the acquired sensing result of contact or adjacency of the operation body, and the acquired sensing result of the movement of the terminal.

2. The information processing apparatus according to claim 1,
wherein the operation face has a curved surface.

3. The information processing apparatus according to claim 1,
wherein the terminal is a wristband terminal that is worn on an arm of an operator.

4. The information processing apparatus according to claim 3,
wherein the movement of the terminal is a rotational movement.

5. The information processing apparatus according to claim 4,
wherein the processing unit executes a different process, depending on a direction toward which the terminal rotationally moves with the operation body in a contact or adjacent state.

6. The information processing apparatus according to claim 1
wherein the processing unit differentiates a process executed when the movement of the terminal and contact or adjacency of the operation body are sensed, from a process executed when contact or adjacency of the operation body is sensed while the movement of the terminal is not sensed.,

7. The information processing apparatus according to claim 1
Wherein the processing unit causes a display unit to present a display corresponding to the sensing result of contact or adjacency of the operation body and the sensing result of the movement of the terminal.

8. The information processing apparatus according to claim 7,
wherein the operation face is superposed on the display unit.

9. The information processing apparatus according to claim 1,
wherein the processing unit differentiates a process executed when contact or adjacency of the operation body is sensed first and the movement of the terminal is sensed later, from a process executed when the movement of the terminal is sensed first and contact or adjacency of the operation body is sensed later.

10. The information processing apparatus according to claim 1,
wherein the operation body is a plurality of fingers of an operator, and
wherein the processing unit executes a process corresponding to a sensing result of contact or adjacency of the plurality of fingers and the sensing result of the movement of the terminal.

11. The information processing apparatus according to claim 10,
wherein the processing unit executes a different process, depending on the finger that is in contact or adjacent.

12. The information processing apparatus according to claim 1,
wherein the operation face is a flat surface.

13. The information processing apparatus according to claim 12,
wherein the movement of the terminal is a translatory movement.

14. An information processing method comprising:
acquiring sensing results from a first sensing unit and a second sensing unit, the first sensing unit sensing contact or adjacency of an operation body to an operation face of a terminal, the second sensing unit sensing a movement of the terminal; and
executing, by a processor, a process corresponding to the acquired sensing result of contact or adjacency of the operation body, and the acquired sensing result of the movement of the terminal.

15. A program causing a computer to execute:
acquiring sensing results from a first sensing unit and a second sensing unit, the first sensing unit sensing contact or adjacency of an operation body to an operation face of a terminal, the second sensing unit sensing a movement of the terminal; and
executing a process corresponding to the acquired sensing result of contact or adjacency of the operation body, and the acquired sensing result of the movement of the terminal.
